# EUROPEAN PATENT SPECIFICATION

(11) **EP 3 641 135 B1**
(45) Date of publication and mention of the grant of the patent: **03.08.2022**
(21) Application number: 18306359.3
(22) Date of filing: 17.10.2018
(51) Int. Cl.: H03L 1/02, H03L 7/099, H03L 7/23

(54) **FREQUENCY DRIFT DETECTOR, COMMUNICATION UNIT AND METHOD THEREFOR**
FREQUENZDRIFTDETEKTOR, KOMMUNIKATIONSEINHEIT UND VERFAHREN DAFÜR
DÉTECTEUR DE DÉRIVE DE FRÉQUENCE, UNITÉ DE COMMUNICATION ET PROCÉDÉ ASSOCIÉ

(43) Date of publication of application: 22.04.2020
(73) Proprietor: NXP USA, Inc., Austin TX 78735 (US)
(72) Inventor: SAVARY, Pierre, 31023 Toulouse (FR); BOUCHAYER, Matthis, 31023 Toulouse (FR); PAVAO MOREIRA, Cristian, 31023 Toulouse (FR)
(74) Representative: Schmütz, Christian Klaus Johannes

(56) References cited:
- EP-A2- 0 344 991
- WO-A2-2013/060608
- US-A1- 2004 000 956
- US-B1- 9 503 106

## Description

### Field of the invention

The field of the invention relates to a frequency drift detector and a calibration method therefor, for example for use in a frequency synthesizer, and a communication unit, such as an automotive radar unit.

### Background of the invention

Modern automotive frequency-modulated continuous wave (FMCW) radar systems typically use a transceiver composed of a transmitter, a receiver, and a frequency synthesizer source. In many present day wireless communication applications, a frequency synthesizer is used to facilitate the radio frequency communications and is often implemented by way of a phase locked loop (PLL) that often uses a crystal oscillator (XCO) as a reference signal that is used to control a voltage controlled oscillator (VCO). The frequency synthesizer generates (often referred to as 'synthesizes') an output radio frequency (sometimes referred to as a 'local oscillator') signal that is used in the transmission and/or reception of radio frequency signals. Frequency synthesizers are also used to generate the FMCW waveforms required by a radar transmitter.

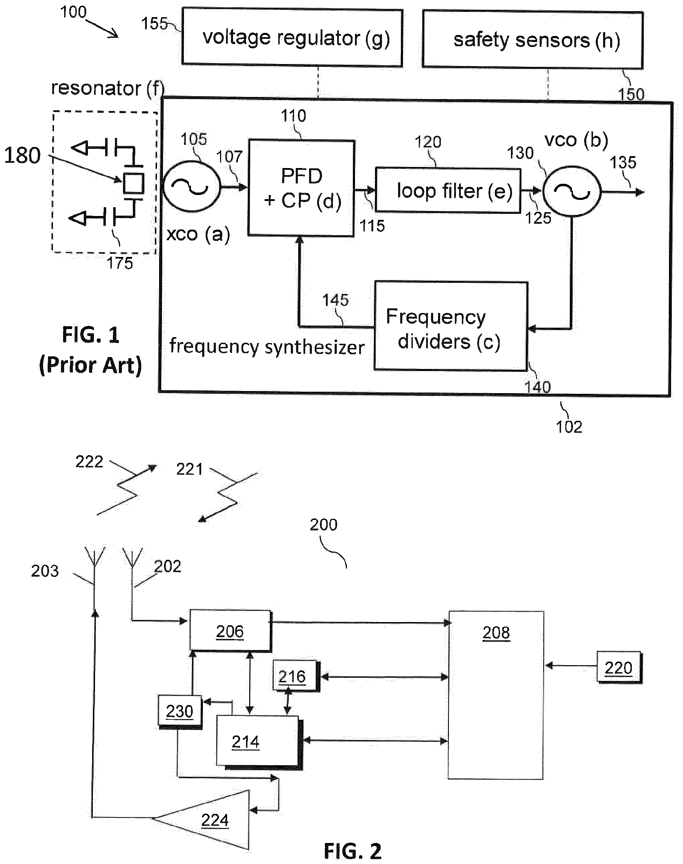

FIG. 1 illustrates a conventional PLL design 100 for a radar unit. A crystal oscillator 105 uses a crystal resonator 180, load capacitors 175 that, in combination, constitute the resonator. The crystal oscillator 105 generates a resonant input frequency 107 that is provided to frequency synthesizer 102 that includes a phase frequency detector (PFD) and charge pump (CP) 110, which compares a feedback signal 145 to the generated resonant input frequency 107, and outputs an oscillator control signal 115 based on the comparison of the feedback signal 145 to the generated resonant input frequency 107. A low pass loop filter 120 filters the oscillator control signal 115, and outputs a filtered oscillator control signal 125, which is provided to a voltage controlled oscillator (VCO) 130. The VCO 130 outputs a radio frequency signal 135 based on the filtered oscillator control signal 125. A feedback path of the PLL 100 consists of a frequency divider 140 that divides the output radio frequency signal 135 to generate a frequency-divided feedback signal 145, which is provided to the PFD and CP 110.

Typically, in such frequency synthesizers 102 there is also a voltage regulator 155 to provide a constant DC voltage to the PLL circuits and components, and safety sensors 150, such as over-voltage and under-voltage detectors connected to the voltage regulator 155, and, say, a PLL unlock monitor connected to the PLL (not shown).

However, the reference frequency 107 may exhibit a variation due to temperature changes, voltage changes, component ageing, etc. This variation is typically predetermined during design and verified during testing, to ensure that the PLL design can operate across all possible variations or real-life use. Nevertheless, a potential risk of a radar device malfunction occurs due to such excessive frequency drift (i.e., higher than this possible pre-determined variation) of the crystal oscillator 105 output frequency 107, for example due to excessive variations of the crystal resonator 180 or of the load capacitors (e.g. a solder break, or abnormal ageing, for example). A consequence of a frequency drift that is higher than this known variation could be a transmitted signal that falls outside of regulated radio frequency bandwidths. In particular, for example in an automotive radar device application, such a frequency drift may occur without any detection by any PLL safety sensor, such as an unlock detector. In this specific situation, the crystal oscillator 105 would still be functional, but its frequency will shift by a few percent, and this drifted frequency is then provided to the PLL. The PLL needs to have a frequency range higher than the radar device operating range in order to withstand the possible process, temperature and supply variations (PVT). This means that, in practice, the PLL can remain locked outside the desired operating frequency range due to the crystal oscillator 105 frequency drift. Traditional safety detectors, such as the PLL unlock monitor, will not be triggered, i.e., an error signal such as a flag will not be initiated.

Traditional methods exist to detect a frequency drift in synthesizer. However, these traditional methods use a relative measurement with a second known frequency. For example, US 6064270A describes a system and method for compensating for reference frequency drift in a communications system that uses a reference frequency for the comparison step. Other known frequency synthesizers transform the clock signal into digital spectra through use of an ADC (whereby the ADC clock is used as the second known frequency in this case) and a Fourier transform. However, with radar transceivers in the field (i.e. mounted in a car for example), it is not possible to detect any frequency drift by comparing crystal oscillator 105 output frequency 107 frequency with a second known frequency, because all transceiver frequencies are referenced to the crystal oscillator 107, which is the frequency that is susceptible to excess frequency drift.

WO 2013/060608 A2 discloses a method and apparatus for compensating for temperature variation in a phase locked loop (PLL), which includes receiving an error signal by a controller in which the error signal representative of an instantaneous frequency difference between a reference frequency signal and an output frequency signal of a voltage controlled oscillator of the PLL, and determining when a voltage of the error signal is outside of a predetermined voltage range.

US 2004/0000956 A1 discloses a PLL frequency synthesizer able to automatically set an appropriate operating mode of the voltage controlled oscillator.

US 9,503,106 B1 discloses an integrated circuit that includes a frequency-locked voltage regulated loop.

EP 0344991 A2 discloses an AFC apparatus effectively used for a satellite broadcasting receiver.

### Summary of the invention

The present invention provides a frequency drift detector and a calibration method therefor, such as defined in the appended independent claims.

Specific embodiments of the invention are set forth in the dependent claims.

These and other aspects of the invention will be apparent from and elucidated with reference to the embodiments described hereinafter.

### Brief description of the drawings

Further details, aspects and embodiments of the invention will be described, by way of example only, with reference to the drawings. In the drawings, like reference numbers are used to identify like or functionally similar elements. Elements in the figures are illustrated for simplicity and clarity and have not necessarily been drawn to scale.
FIG. 1 illustrates a conventional phase locked loop block diagram.
FIG. 2 illustrates a simplified block diagram of a communication unit, such as a radar device, adapted in accordance with examples of the invention.
FIG. 3 illustrates a more detailed block diagram of a communication unit, such as a radar device, transceiver and controller of a communication unit in accordance with examples of the invention.
FIG. 4 illustrates a simplified block diagram of a first example of a frequency drift detector used as a safety sensor associated with a frequency synthesizer for use in the communication unit of FIG. 3, in accordance with examples of the invention.
FIG. 5 illustrates an example of the architecture implementation of a frequency to voltage converter (450) shown in FIG. 4, in accordance with examples of the invention.
FIG. 6 illustrates a simplified block diagram of a second example of the architecture implementation of a frequency to voltage converter (450) shown in FIG. 4, in accordance with examples of the invention.
FIG. 7 illustrates a simplified flowchart of an example of a calibration method of a frequency drift detector (e.g. at T0 when the circuit (such as a frequency synthesizer) is at final or production test and before the circuit is integrated into the communication unit, such as a radar module), in accordance with examples of the invention.
FIG. 8 illustrates an example of a safety sensor detector functionality in a radar device, in accordance with examples of the invention.

### Detailed description

In accordance with the present invention, there is provided a frequency drift detector and a method of calibrating frequency drift detection, for example where a frequency drift variation may be higher than an expected frequency drift range. The frequency drift detector circuit (and associated method(s)) use a frequency to voltage converter to provide an indication of the frequency drift as a voltage, and compares this converted voltage to a known calibrated voltage. In this manner, the inventors have recognised that a parameter associated with a frequency drift variation, rather than an unusable (reference) frequency signal, may be assessed through a comparison operation, thereby circumventing the aforementioned current problem found in communication units, such as modern radar units.

It is envisaged that the frequency drift detection of the crystal oscillator output is converted into a DC voltage that can be compared with a regulated voltage that is already considered and monitored by a safety sensor. If the measured DC voltage is outside a given voltage range, e.g. corresponding to a known excessive frequency drift (say based on crystal oscillator temperature and aging specified values), an error signal will be triggered.

In some examples, the output voltage range of the frequency to voltage converter (FVC), corresponding to the pre-determined crystal oscillator output frequency, may be calibrated during a final test of the transceiver (say, by trimming, which encompasses adjusting component values of the FVC), using an external source. In this manner, the detection of a frequency drift, in order to identify an indication of malfunction of the resonator/oscillator, ensures that, upon start-up of the transceiver or radar unit, the crystal oscillator output frequency starts at a suitable frequency within a desired frequency range. In some examples, the voltage references of the comparator corresponding to a frequency drift limit may also be trimmed. In the context of the present invention, the term trimming encompasses adjusting voltage references of the comparator corresponding to a frequency drift limit by changing resistor values, whilst measuring the voltage references up to the moment that the voltage target is reached. The trimming operation may be performed at a final test, in order to compensate for any process variation.

In some examples, it is envisaged that the frequency drift detection may be initiated as part of safety sensors implemented in radar transceivers for automotive applications. Safety sensors are part of the safety mechanisms implemented in a system to detect and possibly mitigate any variation outside of a defined range that would lead to the violation of the system safety goals. In this manner, the frequency drift of the reference (e.g. crystal) oscillator, used in a radar transceiver for automotive, can be detected and, thus, a potential out-of-band emission by the radar transceiver avoided.

Although examples of the invention are described with reference to a frequency drift detector for a reference clock of a PLL, it is envisaged that other examples may be applied to any fixed and unmodulated clock frequency (i.e. the frequency remains constant other than due to the 'normal' variations from PVT and ageing).

Although examples of the invention are described with reference to a frequency drift detector that uses a FVC in a PLL circuit, it is envisaged that the FVC may be used in other examples.

Referring to FIG. 2, a block diagram of a wireless communication unit is shown, adapted in accordance with some examples of the invention. Purely for explanatory purposes, the wireless communication unit is described in terms of a radar device 200 operating at millimeter wave (MMW) frequencies. The radar device 200 contains one or several antennas 202 for receiving radar signals 221, and one or several antennas 203 for transmitting radar signals 222, with one shown for each for simplicity reasons only. The number of antennas 202, 203 used may depend on the number of radar receiver and transmitter channels that are implemented in a given radar device. One or more receiver chains, as known in the art, include receiver front-end circuitry 206, effectively providing reception, frequency conversion, filtering and intermediate or base-band amplification, and finally an analog-to-digital conversion. In some examples, a number of such circuits or components may reside in signal processing module 208, dependent upon the specific selected architecture. The receiver front-end circuitry 206 is coupled to the signal processing module 208 (generally realized by a digital signal processor (DSP)). A skilled artisan will appreciate that the level of integration of receiver circuits or components may be, in some instances, implementation-dependent.

The controller 214 maintains overall operational control of the radar device 200, and in some examples may comprise time-based digital functions (not shown) to control the timing of operations (e.g. transmission or reception of time-dependent signals, FMCW modulation generation, etc.) within the radar device 200. The controller 214 is also coupled to the receiver front-end circuitry 206 and the signal processing module 208. In some examples, the controller 214 is also coupled to a memory device 216 that selectively stores operating regimes, such as decoding/encoding functions, and the like.

As regards the transmit chain, this essentially comprises a power amplifier (PA) 224 and possibly a phase shifter coupled to the transmitter's one or several antennas 203, antenna array, or plurality of antennas. In radar device 200, radar transceiver topology is different from traditional wireless communication architectures (e.g. Bluetooth^{™}, WiFi^{™}, etc.), as modulation occurs within a phase locked loop (PLL) (typically via a fractional-N divider), and is applied directly to the PA 224. Therefore, in some examples, the receiver front-end circuitry 206 and transmitter PA 224 are coupled to frequency generation circuit 230 arranged to provide local oscillator signals. The generated local oscillator signals are thus modulated directly to generate transmit radar signals, and also used to down-convert received modulated radar signals to a final intermediate or baseband frequency or digital signal for processing in a receive operation.

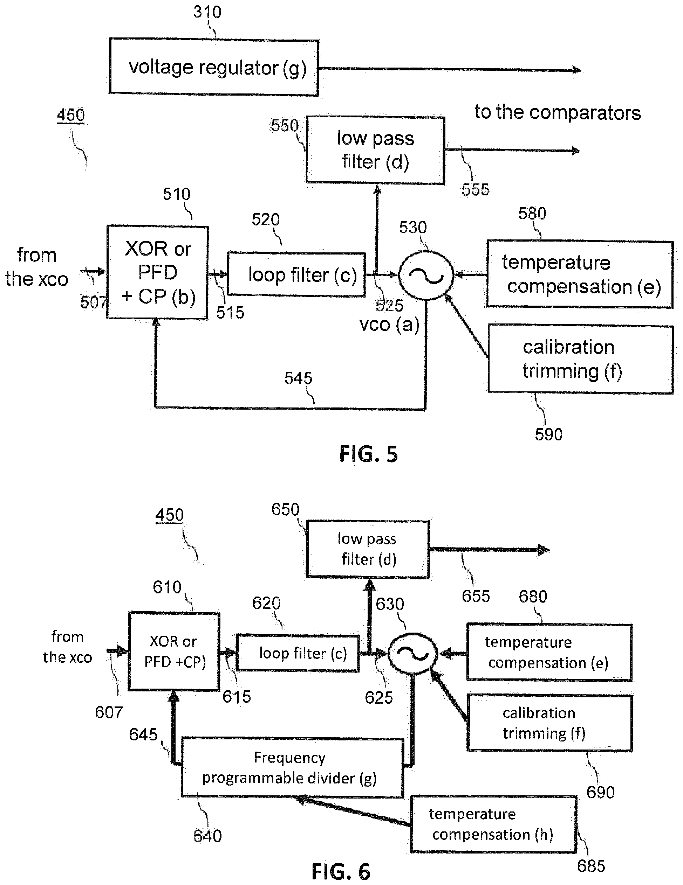

In accordance with examples of the invention, frequency generation circuit 230 includes a frequency drift detector, composed of a frequency to voltage converter and voltage comparators, as further described in the examples illustrated in FIG. 5 and FIG. 6. In accordance with examples of the invention, the frequency to voltage converter includes an XOR logic gate or phase frequency detector plus charge pump circuit arranged to receive the reference frequency and convert it to a representative voltage. In accordance with examples of the invention, the frequency to voltage converter further includes a loop filter and a voltage controlled oscillator (VCO) and a feedback loop. The PLL-based application for the FVC is particularly useful because the frequency range (e.g. the reference frequency normal operating range) can be easily adjusted by adjusting the VCO frequency range, and the PVT variations can be easily compensated as well as described herein. The frequency generation circuit 230 includes a reference oscillator (such as a crystal oscillator) configured to generate a signal that describes, say, a desired frequency modulated continuous wave.

In some examples, a phase/frequency comparator (configured as a phase frequency detector and charge pump) is arranged to compare the output from the reference oscillator and a signal fed back from the VCO via the feedback loop and output a voltage signal that is representative of the reference oscillator output signal, notably indicating any associated frequency drift.

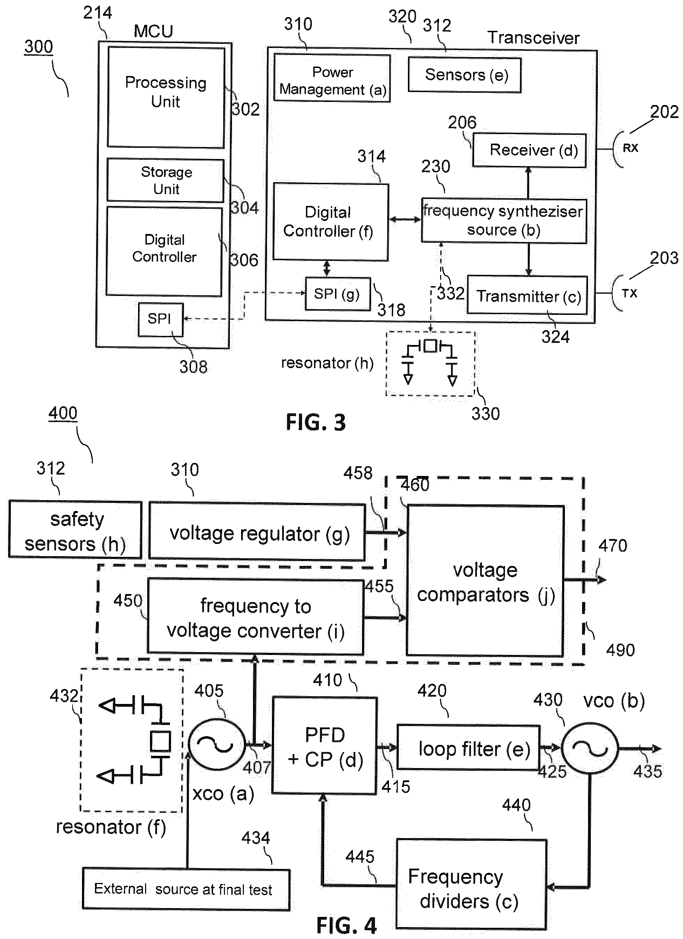

In some examples, the frequency to voltage converter output voltage (that represents the reference frequency) is compared to a known calibrated voltage, such as a regulated supply voltage, in order to determine a frequency drift variation of the reference oscillator, as described with reference to FIG. 4.

A skilled artisan will appreciate that the level of integration of circuits or components may be, in some instances, implementation-dependent.

Referring now to FIG. 3, a more detailed block diagram of a communication unit 300, such as a radar device, transceiver 320 and controller 214 within the communication unit 300, is illustrated in accordance with examples of the invention. In this example, the automotive radar device consists of a multi-chip solution combining the transceiver 320, a processing unit (e.g. a microcontroller unit (MCU)) 214 and antennas 202, 203.

The transceiver 320 comprises a number of circuits and/or components, including: a power management unit 310, a frequency generation circuit 230, a transmitter circuit 324, a receiver circuit 206, a number of sensors 312, e.g. different sensors configured to perform various system tests, a digital controller 314, at least one interface 318 and, in this example, an external crystal resonator 330 connected to the crystal oscillator inside 230.

The controller 214 includes a processing unit 302, a storage unit 204 and a further digital controller 306. The controller 214 also includes at least one interface 308, which is a serial-to-parallel interface (SPI) in the illustrated example, connected to the at least one interface 318 of the transceiver 320.

In order to be able to achieve an acceptable safety level in the overall radar device, each portion of the radar device must be compliant with that safety requirement level. Safety compliance at a transceiver may be achieved by implementing multiple separate sensor functions, often known as safety mechanisms. These safety/sensor mechanisms are responsible for detecting system malfunctioning within the radar device.

Thus, in some examples, the frequency generation circuit 230 includes a frequency to voltage converter arranged to receive the reference frequency and convert it to a representative voltage. The frequency generation circuit 230 is coupled to (or includes) a reference oscillator (such as a crystal oscillator) configured to generate a reference frequency signal that describes, say, a desired frequency continuous wave. The reference frequency signal is converted to a voltage by frequency to voltage converter, where the converted voltage is also indicative of any frequency drift of the reference frequency signal, and the converted voltage is compared with a known voltage, e.g. a regulated voltage from power management unit 310. The output of the comparison indicates when a frequency drift has exceeded a desired limit, as the frequency drift detector may form, in essence, part of the safety sensors 312.

In this manner, the inventors have recognised that a parameter associated with a frequency drift variation may be evaluated through a comparison (e.g. voltage comparison) operation, thereby circumventing the problem that a variation in a crystal oscillator output, which is, in effect, the reference frequency of the transceiver, cannot be compared to another (unaltered) reference frequency, as known radar units utilise the reference frequency as a basis for all subsequent clock and frequency signals.

FIG. 4 illustrates a simplified block diagram 400 of a first example of a frequency drift detector 490 used as a safety sensor of the synthesizer 230 for use in the radar device of FIG. 3, in accordance with examples of the invention. One or more safety sensors 312, such as over-voltage and under-voltage detectors, and one or more voltage regulator 310 is provided. The frequency synthesizer 230 comprises a crystal oscillator 405 that generates a resonant input frequency 407, which is provided to a phase frequency detector (PFD) and charge pump (CP) 410, which compares a feedback signal 445 to the generated resonant input frequency 407, and outputs an oscillator control signal 415 based on the comparison of the feedback signal 445 to the generated resonant input frequency 407. A low pass loop filter 420 filters the oscillator control signal 415, and outputs a filtered oscillator control signal 425, which is provided to the VCO 430. The VCO 430 outputs a radio frequency signal 435 based on the filtered oscillator control signal 425. A feedback path of the PLL consists of a frequency divider 440 that divides the output radio frequency signal 435 to generate a frequency-divided feedback signal 445, which is provided to the PFD and CP 410.

In this example, the generated resonant input frequency 407 is also input to a frequency drift detection circuit 490 that includes a frequency-to-voltage converter 450 that is configured to output a voltage 455 that is representative of the generated resonant input frequency 407. Notably, this output voltage 455 will also include an indication of any frequency drift exhibited by the crystal oscillator 405. The voltage 455 output from the frequency to voltage converter 450 is input to a voltage comparator 460, where it is compared with a regulated voltage 458 from voltage regulator 310. If the voltage 455 output from the frequency to voltage converter 450 exceeds a threshold that is set by the regulated voltage from voltage regulator 310, which is also used as a regulated voltage to other components and circuits in the PLL, the voltage comparator 460 outputs an error signal, say in a form of a generated flag 470, which indicates that an excessive frequency drift has occurred. Such a situation may occur due to abnormal component ageing or failure, etc. of the crystal oscillator 405 or resonator 432. In some examples, the frequency drift detector 490 may be coupled to a safety sensor 312, or in some instances the frequency drift detector may become part of the safety sensors 312, and function as a safety sensor identifying an excessive frequency drift, in response to the FVC output voltage 455 exceeding a frequency drift level represented by the at least one regulated voltage 458.

The frequency to voltage converter 450 of the frequency drift detector circuit 490 employs a simple PLL approach, as shown in FIG. 5 and FIG. 6, as a PLL uses a relatively a small area and requires a low power consumption in a case of integration in an integrated circuit.

In some examples of the invention, during a calibration phase of the frequency drift detector 490, the use of an external source 434 facilitates a measurement of the FVC output voltage over a given frequency range. This voltage range will vary from sample to sample. The external source 434 emulates the resonator 432 variation (over temperature, ageing, process variations), over a well-known (or pre-determined) frequency range. The calibration allows the designer to trim the FVC for each part, in order to adjust the output voltage range to be compatible with the voltage comparator 460, and the voltage comparator 460, itself, may also be adjusted. In some examples of the invention, it is envisaged that the FVC voltage range may not be adjusted due to process variation for example, and the comparator range only is adjusted in order to fit the FVC range.

In some examples, the absolute output voltage range of the frequency to voltage conversion is configured to be compatible with a voltage accuracy of the voltage comparator 460.

In some examples, the frequency to voltage conversion is monotonic, where the linearity of the conversion from frequency to voltage depends on a VCO voltage to frequency conversion curve. In some examples, the frequency to voltage conversion may not necessarily be linear, as the goal of the frequency to voltage conversion in the frequency drift detector 490 is to detect whether (or not) a threshold is exceeded.

In some examples, it is envisaged that a frequency drift variation detection of the crystal oscillator output is converted into a DC voltage that can be compared with a regulated voltage 458, which in some examples is already considered by a safety sensor. If the measured DC voltage output from the frequency to voltage converter circuit is outside a given voltage range, e.g. corresponding to a known drift (say based on crystal oscillator temperature, process, and aging specified values), an error signal will be triggered by voltage comparator 460.

In some examples, it is envisaged that the frequency drift variation detection may be initiated as part of safety sensors implemented in radar transceivers for automotive applications. In this example, the output voltage range of the frequency to voltage converter (FVC) 450 corresponding to a pre-determined (or known) crystal oscillator output frequency 407 may be calibrated during a final test of the transceiver (say, by trimming), using an external source 434, in order to emulate the resonator 'normal' variation (with respect to temperature, process, ageing). In some examples, the voltage references of the comparator corresponding to the frequency drift limit may also be trimmed at a final test, in order to compensate for any expected PVT variation. In some examples, embodiments of the invention propose to compensate at least for the regulator/comparator process variations sample to sample, and in some examples to adjust the comparator window based on each part FVC output voltage.

FIG. 5 illustrates a first example implementation of a PLL based frequency to voltage converter (FVC), such as frequency to voltage converter 450 shown in FIG. 4, in accordance with the invention. The PLL based FVC 450 includes a VCO 530, in accordance with the invention. A reference frequency, such as resonant input frequency 507, is input from a crystal oscillator. The reference frequency is provided to a phase frequency detector (PFD) and charge pump (CP) 510, which compares a feedback signal 545 to the generated resonant input frequency 507, and outputs a control signal 515 based on the comparison of the feedback signal 545 to the generated resonant input frequency 507. A low pass loop filter 520 filters the control signal 515, and outputs a filtered control signal 525, which is provided to the VCO 530. The VCO 530 outputs a radio frequency signal to a feedback path of the PLL based on the filtered oscillator control signal 525. The feedback path 545 of the PLL is provided to the PFD and CP 510.

The filtered control signal 525 of the PLL based FVC 450 is input to a low pass filter 550, which is configured to output a DC voltage 555 that is representative of the generated resonant input frequency 507. In this context, the loop filter 520 is optimized for PLL loop stability, whilst the additional low pass filter 550 is included in order to filter the noise and also filter the clock (reference) frequency. Indeed, the clock frequency from the reference may not be attenuated enough by the loop filter, for example in a case of a (1^{st} order) XOR 510 based PLL, where the loop filter band is fixed by the loop stability only, in contrast to, say, a (2^{nd} order) PFD and CP 510 based PLL.

Notably, this voltage 555 will also include an indication of any frequency drift exhibited by the crystal oscillator. The voltage 555 output from the low pass filter 550 is input to a voltage comparator, where it is compared with the voltage regulated voltage from voltage regulator 310, which is also used as a regulated voltage to other components and circuits in the PLL. If the voltage 555 output from the low pass filter 550 exceeds a threshold that is set by the regulated voltage from voltage regulator 310, the voltage comparator generates a flag, e.g. a digital flag, which indicates that an excessive drift has occurred. Such a situation may occur due to abnormal behaviour of the crystal oscillator and/or the crystal resonator (for example a component solder break or abnormal ageing).

Although this example illustrates a divide-by-one type PLL, it is envisaged that in other examples a PLL with a higher division ratio may be used, as illustrated in FIG. 6. Although this example illustrates a use of a PFD+CP 510 PLL based FVC 450, it is envisaged that in other examples a phase detector, such as an XOR logic gate, may be used. In some examples, the VCO 530 may be temperature compensated, so that its tuning voltage 525 is constant over temperature. In some examples, the VCO 530 may be trimmed by adjusting its resonant circuit (e.g. through adjustment of one or more resistor(s), capacitor(s) or inductor(s)) so that its tuning voltage 525 is the same from sample to sample (which in some alternative examples may be considered as circuit to circuit or IC to IC or die to die.) independently from any process variation.

In some examples, the loop filter 520 may also be adjusted to have a correct loop operation, thereby ensuring stability of the whole PLL. The tuning voltage of the VCO is used as the output voltage, as it is directly a function of the crystal oscillator frequency. This tuning voltage may need to be filtered in XOR logic gate or PFD+CP 510 in order to remove any remaining loop frequency signal.

The PLL based FVC 450 architecture is particularly useful because the frequency range (e.g. the reference frequency normal operating range) can be easily adjusted by adjusting the VCO frequency range, and the PVT variations can be easily compensated as well as described herein. The architecture in FIG. 5 is also beneficial in that it supports reduced die size and current consumption.

FIG. 6 illustrates a second example of a frequency to voltage converter implementation, such as frequency to voltage converter 450 shown in FIG. 4, in accordance with the invention. The frequency to voltage converter includes a VCO 630, in accordance with the invention. Again a reference frequency, such as resonant input frequency 607, is input from a crystal oscillator. The reference frequency is provided to a detector 610, for example in a form of an XOR logic gate or phase frequency detector (PFD) and charge pump (CP), which compares a feedback signal 645 to the generated resonant input frequency 607, and outputs a control signal 615 based on the comparison of the feedback signal 645 to the generated resonant input frequency 607. A low pass loop filter 620 filters the control signal 615, and outputs a filtered control signal 625, which is provided to the VCO 630. The VCO 630 outputs a radio frequency signal to a feedback path of the PLL based on the filtered oscillator control signal 625. The feedback path of the PLL includes a frequency divider in a form of a programmable frequency divider 640 that divides the output radio frequency signal to generate a frequency-divided feedback signal 645, which is provided to the detector 610.

In this example, the filtered control signal 625 is input to a low pass filter 650, which is configured to output a DC voltage 655 that is representative of the generated resonant input frequency 607. Notably, this voltage 655 will also include an indication of any frequency drift exhibited by, say the crystal oscillator. The voltage 655 output from the low pass filter 650 is input to a voltage comparator (not shown), where it is compared with the voltage regulated voltage from voltage regulator (not shown), which is also used as a regulated voltage to other components and circuits in the PLL. If the voltage 655 output from the low pass filter 650 exceeds a threshold that is set by the regulated voltage from a voltage regulator (not shown), the voltage comparator generates a flag, e.g. a digital flag, which indicates that an excessive drift has occurred. Such a situation may occur due to abnormal behaviour of the crystal oscillator/resonator (for example a component solder break or abnormal ageing).

Although this example illustrates a use of a PFD+CP 610 PLL based FVC 450, it is envisaged that in other examples a phase detector, such as an XOR logic gate, may be used. In some examples, the VCO 630 may be temperature compensated, so that its tuning voltage 625 is constant over temperature. In some examples, the VCO 630 may be trimmed by adjusting its resonant circuit (e.g. through adjustment of one or more resistor(s), capacitor(s) or inductor(s)) so that its tuning voltage 625 is the same from sample to sample independently from any process variation.

Alternatively, or additionally, temperature compensation 685 may be applied to the frequency-divided feedback signal 645 via programmable frequency divider 640, such that the filtered control signal (e.g. VCO tuning voltage) 625 is modified according to any prevailing PVT effects.

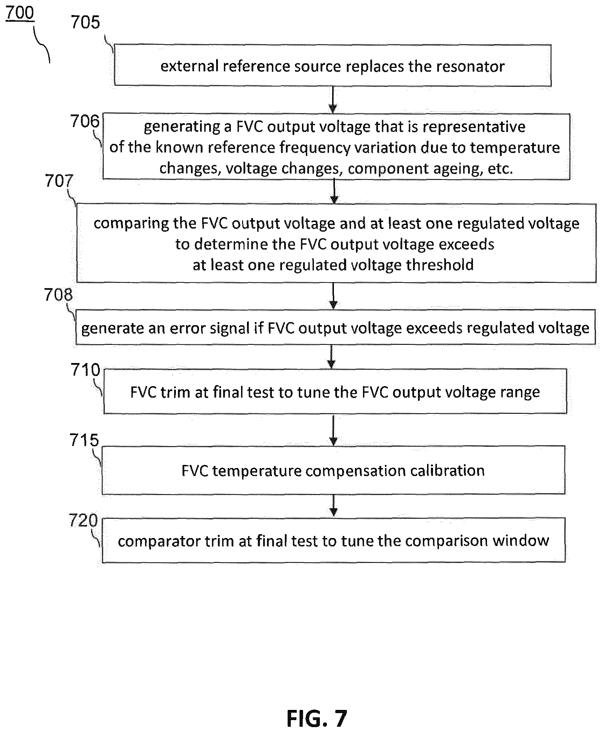

FIG. 7 illustrates a simplified flowchart 700 of an example of a calibration method of a frequency drift detector (e.g. at T0 when a frequency generation circuit is calibrated at a final or production test and before the circuit is integrated into the communication unit, such as a radar module). The simplified flowchart 700 describes one example of determining a frequency drift that can be employed in the circuits of any of FIG's 3 to 6.

At 705, an external source (e.g. external source 434 in FIG. 4) may be used to replace the resonator for the reference oscillator. The operating frequency of this source may be swept in the corresponding reference frequency normal operating condition range that is representative of the known variation due to temperature changes, voltage changes, component ageing, etc. At 706, the flowchart 700 includes generating a FVC output voltage that is representative of the known reference frequency variation due to temperature changes, voltage changes, component ageing, etc. At 707, the flowchart 700 includes comparing the FVC output voltage and the at least one regulated voltage to determine whether the FVC output voltage exceeds at least one regulated voltage threshold. At 708, the flowchart 700 includes generating an error signal that identifies an excessive frequency drift in response to determining that the FVC output voltage exceeds the at least one regulated voltage threshold. It shows in this case that either or both the FVC output voltage and/or the comparator windows have to be tuned (e.g. adjusted) in order to meet the target voltage (as the reference frequency is forced externally in its known normal operating condition range). In some example embodiments of the invention, the FVC output voltage and the comparator thresholds may be measured at final test or production test and compared to known target values.

At 710, a frequency to voltage trim operation (for example adjustment of the resonant circuit such as through adjustment of one or more resistor(s), capacitor(s) or inductor(s)) may be performed at a final test frequency in order to compensate for any process variations, in order to tune the frequency to voltage output voltage range in its known normal operating condition range. In examples of the invention, the trimming operation at 710 may be performed on at least one of: the FVC output voltage, e.g. FVC output voltage 455 of FIG. 4, and/or the at least one regulated voltage, e.g. at least one regulated voltage 458 output from the voltage regulator 310 of FIG. 4, such that the FVC output voltage and/or the at least one regulated voltage fall within a comparator window (normal) operating range.

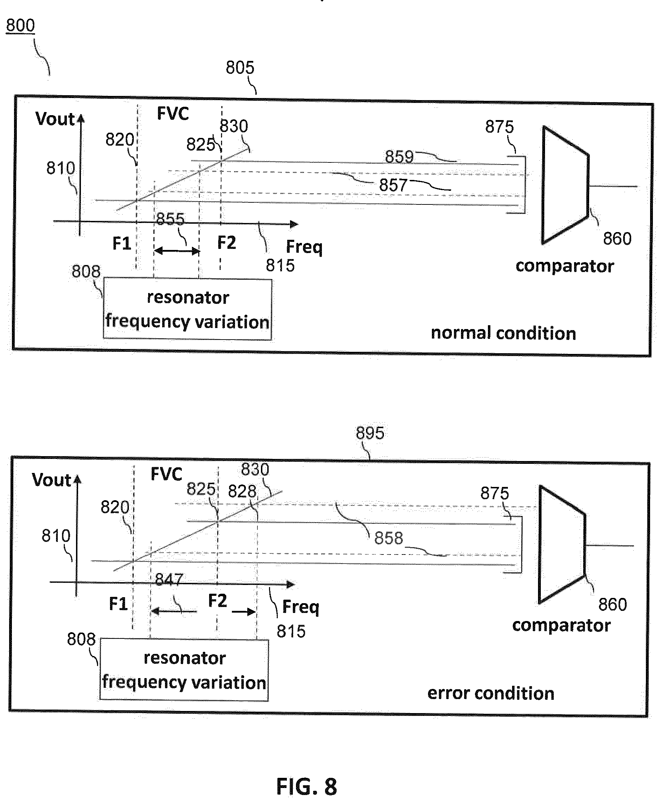

At 715, independently, a frequency to voltage temperature compensation calibration operation may be performed, in order to compensate the temperature change effects of the FVC VCO (e.g. FVC VCO 530 in FIG. 5 or FVC VCO 630 in FIG. 6), so that the FVC output voltage remains constant with the temperature. At 720, a voltage comparator trim operation (e.g. adjustment of the reference voltage by programming or adjusting one or more resistor(s) values) may be performed at a final test voltage in order to tune a voltage comparison window when comparing the output voltage from the frequency to voltage converter and the reference voltage output by the voltage regulator. As the FVC output voltage is adjusted into its known 'normal' range, the comparator window may be adjusted so that the comparator does not raise the flag (i.e. the normal operating example 805 of FIG. 8). As will be appreciated, one or more of the operations at 708, 710 and 715 may be optional and utilised in various examples of the invention, following the comparison operation of 707.

FIG. 8 illustrates graphical examples of a safety sensor detector functionality 800 in a communication unit such as the radar device of FIG. 2, in accordance with examples of the invention. A first graphical example 805 of detector functionality illustrates a normal operating condition and a second graphical example 895 of detector functionality illustrates an error condition, namely one that leads to a flag being generated that indicates an excessive drift of the reference oscillator of the radar device.

The first graphical example 805 of detector functionality illustrates the frequency to voltage conversion output voltage 810 versus reference frequency 815, with an ideal frequency variation range (e.g. a normal operating condition range that is representative of the known variation due to temperature changes, voltage changes, component ageing, etc. ) of the resonator (or crystal oscillator) 855 equating to an acceptable voltage range 857 output from the frequency to voltage converter 830. Notably, in this normal operating condition, the frequency variation range of the resonator (or crystal oscillator) 855 falls within the threshold limit 859, e.g. somewhere between F1 820 and F2 825, that is output from the frequency to voltage converter 830 is observed. Consequently, the range falls within the accuracy voltage limits 875 of the voltage comparator 860, and does not lead to an error signal, such as a flag or error condition.

The second graphical example 895 of detector functionality illustrates the frequency to voltage conversion output voltage 810 versus reference frequency 815 for an error condition. In this error condition, the reference frequency has drifted to a frequency range 847 that exceeds an acceptable performance of the resonator (or crystal oscillator) 857, beyond F2 825 to frequency 828. This equates to a voltage output range 858 from the frequency to voltage converter 830 that falls outside of the accuracy voltage limits 875 of the voltage comparator 860, and leads to a flag or error condition generated by the voltage comparator 860.

In the foregoing specification, the invention has been described with reference to specific examples of embodiments of the invention. It will, however, be evident that various modifications and changes may be made therein without departing from the scope of the invention as set forth in the appended claims.

Furthermore, because the illustrated embodiments of the present invention may for the most part, be implemented using electronic components and circuits known to those skilled in the art, details will not be explained in any greater extent than that considered necessary as illustrated above, for the understanding and appreciation of the underlying concepts of the present invention and in order not to obfuscate or distract from the teachings of the present invention.

The connections as discussed herein may be any type of connection suitable to transfer signals from or to the respective nodes, units or devices, for example via intermediate devices. Accordingly, unless implied or stated otherwise, the connections may for example be direct connections or indirect connections. The connections may be illustrated or described in reference to being a single connection, a plurality of connections, unidirectional connections, or bidirectional connections. However, different embodiments may vary the implementation of the connections. For example, separate unidirectional connections may be used rather than bidirectional connections and vice versa. Also, a plurality of connections may be replaced with a single connection that transfers multiple signals serially or in a time multiplexed manner. Likewise, single connections carrying multiple signals may be separated out into various different connections carrying subsets of these signals. Therefore, many options exist for transferring signals.

Furthermore, those skilled in the art will recognize that boundaries between the above described operations are merely illustrative. The multiple operations may be executed at least partially overlapping in time. Moreover, alternative example embodiments may include multiple instances of a particular operation, and the order of operations may be altered in various other embodiments.

Also for example, in one embodiment, the illustrated examples may be implemented as circuitry located on a single integrated circuit or within a same device. Alternatively, the examples may be implemented as any number of separate integrated circuits or separate devices interconnected with each other in a suitable manner.

The specifications and drawings are, accordingly, to be regarded in an illustrative rather than in a restrictive sense.

In the claims, any reference signs placed between parentheses shall not be construed as limiting the claim. The word 'comprising' does not exclude the presence of other elements or steps then those listed in a claim. Furthermore, the terms 'a' or 'an,' as used herein, are defined as one, or more than one. Also, the use of introductory phrases such as 'at least one' and 'one or more' in the claims should not be construed to imply that the introduction of another claim element by the indefinite articles 'a' or 'an' limits any particular claim containing such introduced claim element to inventions containing only one such element, even when the same claim includes the introductory phrases 'one or more' or 'at least one' and indefinite articles such as 'a' or 'an.' The same holds true for the use of definite articles. Unless stated otherwise, terms such as 'first' and 'second' are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage.

## Claims

1. A frequency drift detector (490) comprising:
a frequency-to-voltage converter, FVC, (450) arranged to receive a reference frequency signal (407) from a crystal oscillator (405) and configured to generate an FVC output voltage (455);
a voltage regulator (310) arranged to output at least one regulated voltage, wherein the at least one regulated voltage is representative of a known frequency drift level of the crystal oscillator (405); and
a voltage comparator (460) coupled to an output of the FVC (450) and an output of the voltage regulator (310) and arranged to compare the FVC output voltage (455) and the at least one regulated voltage (458) and generate an error signal (470) in response to determining that the FVC output voltage (455) exceeds the known frequency drift level indicated by the at least one regulated voltage (458) such that the error signal corresponds to an excessive frequency drift of the crystal oscillator (405), wherein the FVC (450) comprises a phase locked loop, PLL, arranged to receive the reference frequency signal (407); wherein the PLL comprises a phase detector (510, 610) configured to compare the reference frequency signal (407, 507, 607) to a feedback signal (545, 645) and output a control signal (515, 615) based on the comparison; a loop filter (520, 620) configured to filter the control signal (515, 615); a voltage controlled oscillator, VCO (530, 630), configured to generate an output radio frequency signal in response to the filtered control signal (525, 625); a feedback path configured to generate the feedback signal (545, 645) based on the output radio frequency signal; and a low pass filter (550, 650) arranged to filter the filtered control signal (525, 625) in order to generate the FVC output voltage (455, 555, 655), wherein the PLL is operably coupled to a temperature compensation circuit (580, 680, 685), such that the temperature compensation circuit (580, 680, 685) is coupled to one or more of:
the VCO (530, 630), and the temperature compensation circuit (580, 680) is arranged to apply a temperature compensation signal to the VCO (430) such that, in response thereto, the filtered control signal (525, 625) is constant over temperature; and
a programmable divider (640) in the feedback path of the PLL, and the temperature compensation circuit (685) is arranged to apply a temperature compensation signal to the programmable divider (640) such that, in response thereto, the filtered control signal (525, 625) is constant over temperature.

2. The frequency drift detector (490) of claim 1, wherein the phase detector circuit (510,610) is an exclusive OR logic gate (510, 610) or a phase-frequency detector plus charge pump circuit (510, 610).

3. The frequency drift detector (490) of any preceding claim, wherein the frequency drift detector (490) is coupled to a safety sensor (312) configured to receive the error signal (470) and raise a flag in response to the FVC output voltage (455) exceeding the known frequency drift level indicated by the at least one regulated voltage (458) comparison.

4. The frequency drift detector (490) of any preceding claim, wherein the frequency drift detector (490) is calibrated during a test mode of operation whereby an external calibrated reference source (434) provides the reference frequency signal (407).

5. The frequency drift detector (490) of any preceding claim, wherein the regulated voltage that is supplied to the voltage comparator (460) that corresponds to the known frequency drift level is trimmed during a test mode of operation to compensate for any process variations in the voltage comparator (460).

6. The frequency drift detector (490) of any preceding claim, wherein the FVC (450) is trimmed during a test mode of operation to compensate for any temperature variation using an input from an external source (434) that is configured to emulate the crystal oscillator variation.

7. The frequency drift detector (490) of claim 6, wherein the VCO (530, 560) of the FVC (450) is temperature compensated, so that the filtered control voltage (525, 625) is constant over temperature.

8. The frequency drift detector (490) of claim 7, wherein the VCO (530,630) comprises a resonant circuit that includes at least two components from a group of: one or more resistor(s), one or more capacitor(s), one or more inductor(s), and the temperature compensation is performed by adjusting at least one of the components of the resonant circuit so that the filtered control voltage (525, 625) is the same from sample to sample.

9. A communication unit comprising:
a frequency drift detector (490) according to any preceding claim; and the crystal oscillator (405).

10. A method (700) for calibrating a frequency drift detector (490) according to any of claims 1 to 9, the method being **characterised by**:
receiving the at least one regulated voltage from the voltage regulator (310);
receiving a reference frequency signal (407) at an input of the FVC (450), and generating the arr FVC output voltage (455) in response thereto,
wherein the reference frequency signal (407) emulates the crystal oscillator (405) over its normal operating condition range;
comparing (707) the FVC output voltage (455) and the at least one regulated voltage (458);
generating (708) the error signal (470) that identifies an excessive frequency drift in response to determining that the FVC output voltage (455) exceeds the at least one regulated voltage (458); and
trimming (710) at least one of: the FVC output voltage (455), the at least one regulated voltage (458) output from the voltage regulator (310), such that the FVC output voltage (455) and/or the at least one regulated voltage (458) fall within a comparator window normal operating range and the comparison does not generate an error signal.

11. The method of claim
10 wherein the reference frequency signal (407) is provided by an external source.

## Patentansprüche

1. Frequenzdriftdektor (490), umfassend:
einen Frequenz-Spannungs-Wandler, FVC (450), angeordnet zum Empfangen eines Referenzfrequenzsignals (407) von einem Quarzoszillator (405) und ausgelegt zum Generieren einer FVC-Ausgangsspannung (455);
einen Spannungsregler (310), der angeordnet ist zum Ausgeben mindestens einer geregelten Spannung, wobei die mindestens eine geregelte Spannung für eine bekannte Frequenzdriftstärke des Quarzoszillators (405) repräsentativ ist; und
einen Spannungsvergleicher (460), der an einen Ausgang des FVC (450) und einen Ausgang des Spannungsreglers (310) gekoppelt und angeordnet ist zum Vergleichen der FVC-Ausgangsspannung (455) und der mindestens einen geregelten Spannung (458) und Erzeugen eines Fehlersignals (470) als Reaktion auf das Bestimmen, dass die FVC-Ausgangsspannung (455) die durch die mindestens eine geregelte Spannung (458) angegebene bekannte Frequenzdrifthöhe übersteigt, so dass das Fehlersignal einer übermäßigen Frequenzdrift des Quarzoszillators (405) entspricht, wobei der FVC (450) einen Phasenregelkreis, PLL, umfasst, der angeordnet ist zum Empfangen des Referenzfrequenzsignals (407), wobei der PLL einen Phasendetektor (510, 610) umfasst, der ausgelegt ist zum Vergleichen des Referenzfrequenzsignals (407, 507, 607) mit einem Rückkopplungssignal (545, 645) und Ausgeben eines Steuersignals (515, 615) auf Basis des Vergleichs;
einen Schleifenfilter (520, 620), der ausgelegt ist zum Filtern des Steuersignals (515, 615); einen spannungsgesteuerten Oszillator, VCO (530, 630), der ausgelegt ist zum Generieren eines Ausgangshochfrequenzsignals als Reaktion auf das gefilterte Steuersignal (525, 625); einen Rückkopplungspfad, der ausgelegt ist zum Generieren des Rückkopplungssignals (545, 645) auf Basis des Ausgangshochfrequenzsignals;
und einen Tiefpassfilter (550, 650), der angeordnet ist zum Filtern des gefilterten Steuersignals (525, 625), um die FVC-Ausgangsspannung (455, 555, 655) zu generieren, wobei der PLL operativ mit einer Temperaturkompensationsschaltung (580, 680, 685) gekoppelt ist, so dass die Temperaturkompensationsschaltung (580, 680, 685) an einen oder mehrere der Folgenden gekoppelt ist:
den VCO (530, 630), und die Temperaturkompensationsschaltung (580, 680) angeordnet ist zum Anlegen eines Temperaturkompensationssignals an den VCO (430), so dass als Reaktion darauf das gefilterte Steuersignal (525, 625) über der Temperatur konstant ist; und
einen programmierbaren Teiler (640) in dem Rückkopplungspfad des PLL, und die Temperaturkompensationsschaltung (685) angeordnet ist zum Anlegen eines Temperaturkompensationssignals an den programmierbaren Teiler (640), so dass als Reaktion darauf das gefilterte Steuersignal (525, 625) über der Temperatur konstant ist.

2. Frequenzdriftdektor (490) nach Anspruch 1, wobei die Phasendetektorschaltung (510, 610) ein Exclusive-OR-Logikgatter (510, 610) oder eine Phasen-Frequenz-Detektor-Plus-Ladepumpenschaltung (510, 610) ist.

3. Frequenzdriftdektor (490) nach einem vorhergehenden Anspruch, wobei der Frequenzdriftdektor (490) an einen Sicherheitssensor (312) gekoppelt ist, der ausgelegt ist zum Empfangen des Fehlersignals (470) und Setzen eines Flag als Reaktion darauf, dass die FVC-Ausgangsspannung (455) die durch den mindestens einen Geregelte-Spannung(458)-Vergleich angegebene bekannte Frequenzdrifthöhe übersteigt.

4. Frequenzdriftdektor (490) nach einem vorhergehenden Anspruch,
wobei der Frequenzdriftdektor (490) während eines Testbetriebsmodus kalibriert wird, wodurch eine externe kalibrierte Referenzquelle (434) das Referenzfrequenzsignal (407) liefert.

5. Frequenzdriftdektor (490) nach einem vorhergehenden Anspruch,
wobei die geregelte Spannung, die an den Spannungsvergleicher (460) geliefert wird, die der bekannten Frequenzdrifthöhe entspricht, während eines Testbetriebsmodus getrimmt wird, um etwaige Prozessschwankungen in dem Spannungsvergleicher (460) zu kompensieren.

6. Frequenzdriftdektor (490) nach einem vorhergehenden Anspruch,
wobei der FVC (450) während eines Testbetriebsmodus getrimmt wird, um eine etwaige Temperaturschwankung unter Verwendung eines Eingangs von einer externen Quelle (434) zu kompensieren, die ausgelegt ist zum Emulieren der Quarzoszillatorschwankung.

7. Frequenzdriftdektor (490) nach Anspruch 6, wobei der VCO (530, 560) des FVC (450) temperaturkompensiert ist, so dass die gefilterte Steuerspannung (525, 625) über der Temperatur konstant ist.

8. Frequenzdriftdektor (490) nach Anspruch 7, wobei der VCO (530, 630) einen Schwingkreis umfasst, der mindestens zwei Komponenten enthält aus einer Gruppe aus: einem oder mehreren Widerständen, einem oder mehreren Kondensatoren, einem oder mehreren Induktoren, und die Temperaturkompensation durchgeführt wird durch Verstellen mindestens einer der Komponenten des Schwingkreises, so dass die gefilterte Steuerspannung (525, 625) von Abtastwert zu Abtastwert gleich ist.

9. Kommunikationseinheit, umfassend:
einen Frequenzdriftdektor (490) nach einem vorhergehenden Anspruch, und den Quarzoszillator (405).

10. Verfahren (700) zum Kalibrieren eines Frequenzdriftdektors (490) nach einem der Ansprüche 1 bis 9, wobei das Verfahren **gekennzeichnet ist durch**:
Empfangen der mindestens einen geregelten Spannung von dem Spannungsregler (310);
Empfangen eines Referenzfrequenzsignals (407) an einem Eingang des FVC (450),
und Generieren der FVC-Ausgangsspannung (455) als Reaktion darauf,
wobei das Referenzfrequenzsignal (407) den Quarzoszillator (405) über seinen normalen Arbeitsbedingungsbereich emuliert;
Vergleichen (707) der FVC-Ausgangsspannung (455) und der mindestens einen geregelten Spannung (458);
Generieren (708) des Fehlersignals (470), das eine übermäßige Frequenzdrift identifiziert, als Reaktion auf das Bestimmen, dass die FVC-Ausgangsspannung (455) die mindestens eine geregelte Spannung (458) übersteigt; und
Trimmen (710) mindestens einer der FVC-Ausgangsspannung (455), der mindestens einen von dem Spannungsregler (310) ausgegebenen geregelten Spannung (458), so dass die FVC-Ausgangsspannung (455) und/oder die mindestens eine geregelte Spannung (458) innerhalb eines normalen Vergleicherfenster-Arbeitsbereichs fallen und der Vergleich kein Fehlersignal generiert.

11. Verfahren nach Anspruch 10, wobei das Referenzfrequenzsignal (407) durch eine externe Quelle bereitgestellt wird.

## Revendications

1. Détecteur de dérive de fréquence (490) comprenant :
un convertisseur fréquence-tension, FVC, (450) agencé de manière à recevoir un signal de fréquence de référence (407) en provenance d'un oscillateur à quartz (405) et configuré pour générer une tension de sortie de FVC (455) ;
un régulateur de tension (310) agencé pour délivrer au moins une tension régulée, la ou les tensions régulées étant représentatives d'un niveau de dérive de fréquence connu de l'oscillateur à quartz (405) ; et
un comparateur de tension (460) couplé à une sortie du FVC (450) et à une sortie du régulateur de tension (310) et agencé pour comparer la tension de sortie de FVC (455) et la ou les tensions régulées (458) et générer un signal d'erreur (470) en réponse à la détermination que la tension de sortie de FVC (455) excède le niveau de dérive de fréquence connu indiqué par la ou les tensions régulées (458) de sorte que le signal d'erreur correspond à une dérive de fréquence excessive de l'oscillateur à quartz (405), le FVC (450) comprenant une boucle à verrouillage de phase, PLL, agencée pour recevoir le signal de fréquence de référence (407) ; la PLL comprenant un détecteur de phase (510, 610) configuré pour comparer le signal de fréquence de référence (407, 507, 607) à un signal de rétroaction (545, 645) et délivrer un signal de commande (515, 615) sur la base de la comparaison ; un filtre de boucle (520, 620) configuré pour filtrer le signal de commande (515, 615) ; un oscillateur commandé par tension, VCO (530, 630), configuré pour générer un signal radiofréquence de sortie en réponse au signal de commande filtré (525, 625) ; un chemin de rétroaction configuré pour générer le signal de rétroaction (545, 645) sur la base du signal radiofréquence de sortie ; et un filtre passe-bas (550, 650) agencé pour filtrer le signal de commande filtré (525, 625) dans le but de générer la tension de sortie de FVC (455, 555, 655), la PLL étant couplée de manière fonctionnelle à un circuit de compensation de température (580, 680, 685), de telle sorte que le circuit de compensation de température (580, 680, 685) est couplé à un ou plusieurs des éléments suivants :
le VCO (530, 630), et le circuit de compensation de température (580, 680) étant agencé pour appliquer un signal de compensation de température au VCO (430) de telle sorte que, en réponse à celui-ci, le signal de commande filtré (525, 625) est constant en fonction de la température ; et
un diviseur programmable (640) dans le chemin de rétroaction de la PLL, et le circuit de compensation de température (685) étant agencé pour appliquer un signal de compensation de température au diviseur programmable (640) de telle sorte que, en réponse à celui-ci, le signal de commande filtré (525, 625) est constant en fonction de la température.

2. Détecteur de dérive de fréquence (490) selon la revendication 1, le circuit de détecteur de phase (510, 610) étant une porte logique OU exclusif (510, 610) ou un détecteur de phase-fréquence avec un circuit de pompe de charge (510, 610).

3. Détecteur de dérive de fréquence (490) selon l'une quelconque des revendications précédentes, le détecteur de dérive de fréquence (490) étant couplé à un capteur de sécurité (312) configuré pour recevoir le signal d'erreur (470) et lever un drapeau en réponse à la tension de sortie de FVC (455) excédant le niveau de dérive de fréquence connu indiqué par la comparaison de la ou des tensions régulées.

4. Détecteur de dérive de fréquence (490) selon l'une quelconque des revendications précédentes, le détecteur de dérive de fréquence (490) étant calibré pendant un mode de test de fonctionnement moyennant quoi une source de référence calibrée externe (434) fournit le signal de fréquence de référence (407).

5. Détecteur de dérive de fréquence (490) selon l'une quelconque des revendications précédentes, la tension régulée qui est fournie au comparateur de tension (460) qui correspond au niveau de dérive de fréquence connu étant ajustée pendant un mode de test de fonctionnement pour compenser des variations de processus quelconques dans le comparateur de tension (460).

6. Détecteur de dérive de fréquence (490) selon l'une quelconque des revendications précédentes, le FVC (450) étant ajusté pendant un mode de test de fonctionnement pour compenser une variation de température quelconque en utilisant une entrée en provenance d'une source externe (434) qui est configurée pour émuler la variation d'oscillateur à quartz.

7. Détecteur de dérive de fréquence (490) selon la revendication 6, le VCO (530, 560) du FVC (450) étant compensé en température, de sorte que la tension de commande filtrée (525, 625) est constante en fonction de la température.

8. Détecteur de dérive de fréquence (490) selon la revendication 7, le VCO (530, 630) comprenant un circuit résonnant qui inclut au moins deux composants dans un groupe de : une ou plusieurs résistances, un ou plusieurs condensateurs, une ou plusieurs inductances, et la compensation de température étant réalisée en adaptant au moins un des composants du circuit résonnant de sorte que la tension de commande filtrée (525, 625) est la même d'un échantillon à l'autre.

9. Unité de communication comprenant :
un détecteur de dérive de fréquence (490) selon l'une quelconque des revendications précédentes ; et
l'oscillateur à quartz (405).

10. Procédé (700) de calibrage d'un détecteur de dérive de fréquence (490) selon l'une quelconque des revendications 1 à 9, le procédé étant **caractérisé par** :
la réception de la ou des tensions régulées en provenance du régulateur de tension (310) ;
la réception d'un signal de fréquence de référence (407) au niveau d'une entrée du FVC (450), et la génération de la tension de sortie de FVC (455) en réponse à celle-ci, le signal de fréquence de référence (407) émulant l'oscillateur à quartz (405) sur sa plage de condition normale de fonctionnement ;
la comparaison (707) de la tension de sortie de FVC (455) et de la ou des tensions régulées (458) ;
la génération (708) du signal d'erreur (470) qui identifie une dérive de fréquence excessive en réponse à la détermination que la tension de sortie de FVC (455) excède la ou les tensions régulées (458) ; et
l'ajustage (710) de : la tension de sortie de FVC (455) et/ou la ou les tensions régulées (458) délivrées par le régulateur de tension (310), de telle sorte que la tension de sortie de FVC (455) et/ou la ou les tensions régulées (458) tombent à l'intérieur d'une plage de fonctionnement normale de fenêtre de comparateur et que la comparaison ne génère pas un signal d'erreur.

11. Procédé selon la revendication 10, le signal de fréquence de référence (407) étant fourni par une source externe.
